# EUROPÄISCHE PATENTSCHRIFT

(11) **EP 3 039 681 B1**
(45) Veröffentlichungstag und Bekanntmachung des Hinweises auf die Patenterteilung: **21.03.2018**
(21) Anmeldenummer: 14777650.4
(22) Anmeldetag: 01.10.2014
(51) Int. Cl.: G11C 7/10, H03K 19/003, H03K 19/0185, H03K 5/003

(54) **PEGELWANDLERSCHALTUNG**
LEVEL SHIFTER CIRCUIT
CIRCUIT CONVERTISSEUR DE NIVEAU

(30) Priorität: 02.10.2013 DE 102013220100
(43) Veröffentlichungstag der Anmeldung: 06.07.2016
(73) Patentinhaber: FRAUNHOFER-GESELLSCHAFT zur Förderung der angewandten Forschung e.V., 80636 München (DE)
(72) Erfinder: SUNDERMEYER, Jan, 90425 Nürnberg (DE); WEBER, Norbert, 91367 Weißenohe (DE)
(74) Vertreter: Burger, Markus
(86) Internationale Anmeldenummer: PCT/EP2014/071086
(87) Internationale Veröffentlichungsnummer: WO 2015/049314

(56) Entgegenhaltungen:
- US-A1- 2002 032 893
- US-B1- 7 948 270
- KENT D LAYTON ET AL: "Analog circuit design at and below VT + 2Vds,sat", MICROELECTRONICS AND ELECTRONICS CONFERENCE, 2007. RME. PH.D. RESEARCH IN, IEEE, PI, 1. Juli 2007 (2007-07-01), Seiten 213-216, XP031189901, ISBN: 978-1-4244-1000-2
- POTANIN V Y ET AL: "High-voltage-tolerant power supply in a low-voltage CMOS technology", PROCEEDINGS / 2004 IEEE INTERNATIONAL SYMPOSIUM ON CIRCUITS AND SYSTEMS : MAY 23 - 26, 2004, SHERATON VANCOUVER WALL CENTRE HOTEL, VANCOUVER, BRITISH COLUMBIA, CANADA, IEEE OPERATIONS CENTER, PISCATAWAY, NJ, 23. Mai 2004 (2004-05-23), Seiten I-393, XP010719135, ISBN: 978-0-7803-8251-0

## Beschreibung

Ausführungsbeispiele der vorliegenden Erfindung beziehen sich auf eine Pegelwandlerschaltung. Weitere Ausführungsbeispiele beziehen sich auf eine Eingangsschaltung mit Eingangstransistoren und einer Pegelwandlerschaltung, die mit den Eingangstransistoren gekoppelt ist. Weitere Ausführungsbeispiele beziehen sich auf ein Verfahren zum Betrieb einer Pegelwandlerschaltung. Manche Ausführungsbeispiele beziehen sich auf einen Pegelwandler für schnelle CMOS-Eingangsschaltungen.

Um eine schnelle Datenübertragung (von z.B. mehr als 1000 MBit pro Sekunde) über verlustbehaftete Kabel zu realisieren, wird eine gesteigerte Sendeleistung benötigt. Moderne CMOS-Technologien besitzen jedoch die Einschränkung, dass schnelle Transistoren (mit einer Strukturgröße kleiner 90nm) eine geringere Spannungsfestigkeit besitzen. Dies ist besonders für Empfängerschaltungen kritisch, da hier eine Pegelwandlung vorgenommen werden muss, die bei höheren Signalpegeln (von z.B. mehr als 1V) nicht mehr mit schnellen Transistoren realisiert werden kann.

Es sind zwei Lösungen zum Lösen dieses Problems bekannt. Gemäß einer ersten Lösung werden hohe Eingangsspannungen komplett vermieden, so dass schnelle Transistoren zum Einsatz kommen können. Dies führt aber zu einer Reduktion der Sendeleistung bzw. schränkt die sonst möglichen Beschaltungen stark ein. Gemäß einer zweiten Lösung werden spannungsfeste, langsamere Transistoren für die Eingangsstufe verwendet, die eine passende Pegelwandlung durchführen. Dies schränkt die maximale Datenrate jedoch ein.

Die Verwendung von spannungsfesten Transistoren führt aufgrund der niedrigen Schaltgeschwindigkeit dieser Transistoren zu einer Eingangsstufe mit niedriger Verstärkung und Bandbreite. Dies verzerrt zum einen das Signal weiter, so dass mehr Maßnahmen zum Bandbreitenausgleich getroffen werden müssen, zum anderen führt eine niedrige Verstärkung zu einem schlechteren Signal-Rausch-Verhältnis, da mehr Verstärkerstufen benötigt werden und mehr Rauschen bei kleineren Signalpegeln zugefügt wird.

In [KENT D LAYTON ET AL: "Analog circuit design at and below VT + 2Vds,sat", MICRO-ELECTRONICS AND ELECTRONICS CONFERENCE, 2007. RME. PH.D. RESEARCH IN, IEEE, PI, 1. Juli 2007 (2007-07-01), Seiten 213-216, XP031189901, ISBN: 978-1-4244-1000-2] wird eine analoge Schaltung beschrieben, die bei einer Versorgungsspannung von VT + 2Cds,sat und darunter arbeitet. Hierzu werden die Eingangsspannungen Vin+ und Vin- um I·R über Widerstände verschoben, so dass die Transistoren der analogen Schaltung betragsmäßig höhere Spannungen an den Gates erhalten. Die Schaltung ist jedoch nicht dazu geeignet, empfängerseitig einen Einsatz von schnellen Transistoren zu ermöglichen, ohne senderseitig auf eine gesteigerte Sendeleistung zu verzichten.

In [POTANIN V Y ET AL: "High-voltage-tolerant power supply in a low-voltage CMOS technology", PROCEEDINGS / 2004 IEEE INTERNATIONAL SYMPOSIUM ON CIR-CUITS AND SYSTEMS : MAY 23 -26, 2004, SHERATON VANCOUVER WALL CENTRE HOTEL, VANCOUVER, BRITISH COLUMBIA, CANADA, IEEE OPERATIONS CENTRE, PISCATAWAY, NJ, 23. Mai 2004 (2004-05-23), Seiten I-393, XP010719135, ISBN: 978-0-7803-8251-0] wird eine Stromversorgungsschaltung beschrieben, die eine Versorgungsspannung erlaubt, die doppelt so hoch ist wie eine herkömmliche Versorgungsspannung eines einzelnen CMOS Transistors.

Die US 7,948,270 B1 beschreibt eine Pegelwandlerschaltung für eine serielle Schnittstelle, die eine differentielle Hochgeschwindigkeitsdatenübertragung zwischen integrierten Schaltungen ermöglicht.

Die US 2002/032893 A1 beschreibt einen Source folgenden Transistor basierten Puffer mit hoher Linearität.

Der vorliegenden Erfindung liegt somit die Aufgabe zugrunde, ein Konzept zu schaffen, welches empfängerseitig einen Einsatz von schnellen Transistoren ermöglicht ohne senderseitig auf eine gesteigerte Sendeleistung zu verzichten.

Diese Aufgabe wird durch die unabhängigen Patentansprüche gelöst.

Ausführungsbeispiele der vorliegenden Erfindung schaffen eine Pegelwandlerschaltung mit einem Eingang mit einem ersten Anschluss und einem zweiten Anschluss, einem Ausgang mit einem dritten Anschluss und einem vierten Anschluss, einem ersten Widerstand, der zwischen dem ersten Anschluss und dem dritten Anschluss geschaltet ist, einem zweiten Widerstand, der zwischen dem zweiten Anschluss und dem vierten Anschluss geschaltet ist, und einer Stromeinstellschaltung, die ausgebildet ist, um einen Strom durch den ersten Widerstand und einen Strom durch den zweiten Widerstand derart zu beeinflussen, dass eine Ausgangsspannung der Pegelwandlerschaltung einen maximal zulässigen Wert nicht überschreitet, wobei die Stromeinstellschaltung eine Stromregelschaltung ist, die ausgebildet ist, um den Strom durch den ersten Widerstand und den Strom durch den zweiten Widerstand basierend auf der Ausgangsspannung zu regeln, wobei die Stromregelschaltung einen Gleichtaktdetektor aufweist, der ausgebildet ist, um einen Gleichtaktpegel der Ausgangsspannung zu ermitteln, wobei der Gleichtaktdetektor einen Spannungsteiler aufweist, der ausgebildet ist, um den Gleichtaktpegel der Ausgangsspannung an einem Mittelpunkt des Spannungsteilers bereitzustellen, wobei die Stromregelschaltung einen ersten Transistor und einen zweiten Transistor aufweist, wobei der erste Transistor ausgebildet ist, um den Strom durch den ersten Widerstand zu beeinflussen, und wobei der zweite Transistor ausgebildet ist, um den Strom durch den zweiten Widerstand zu beeinflussen, wobei Steuerspannungen des ersten Transistors und des zweiten Transistors von dem ermittelten Gleichtaktpegel der Ausgangsspannung abgängig sind, wobei der erste Transistor und der zweite Transistor Feldeffekttransistoren sind, wobei die Gates der Feldeffekttransistoren mit dem Mittelpunkt des Spannungsteilers verbunden sind.

Der vorliegenden Erfindung liegt die Idee zugrunde eine Pegelwandlung z.B. von einem hohen Eingangspegel auf einen für schnelle Transistoren akzeptablen Pegel mittels einer Pegelwandlerschaltung, die einen Widerstand und eine Stromeinstellschaltung aufweist, durchzuführen, wobei der Widerstand zwischen einem Eingang und einem Ausgang der Pegelwandlerschaltung geschaltet ist, und wobei die Stromeinstellschaltung ausgebildet ist, um einen Strom durch den Widerstand derart zu beeinflussen, dass eine Ausgangsspannung der Pegelwandlerschaltung einen maximal zulässigen Wert (z.B. einen für schnelle Transistoren akzeptablen Pegel) nicht überschreitet.

Weitere Ausführungsbeispiele schaffen eine Eingangsschaltung mit Eingangstransistoren und der oben beschriebenen Pegelwandlerschaltung. Die Pegelwandlerschaltung weist einen Eingang mit einem ersten Anschluss und einem zweiten Anschluss, einen Ausgang mit einem dritten Anschluss und einem vierten Anschluss, einen ersten Widerstand, der zwischen dem ersten Anschluss und dem dritten Anschluss geschaltet ist, einen zweiten Widerstand, der zwischen dem zweiten Anschluss und dem vierten Anschluss geschaltet ist, und eine Stromeinstellschaltung auf, die ausgebildet ist, um einen Strom durch den ersten Widerstand und einen Strom durch den zweiten Widerstand derart zu beeinflussen, dass eine Ausgangsspannung der Pegelwandlerschaltung einen maximal zulässigen Wert nicht überschreitet, wobei die Stromeinstellschaltung eine Stromregelschaltung ist, die ausgebildet ist, um den Strom durch den ersten Widerstand und den Strom durch den zweiten Widerstand basierend auf der Ausgangsspannung zu regeln, wobei die Stromregelschaltung einen Gleichtaktdetektor aufweist, der ausgebildet ist, um einen Gleichtaktpegel der Ausgangsspannung zu ermitteln, wobei der Gleichtaktdetektor einen Spannungsteiler aufweist, der ausgebildet ist, um den Gleichtaktpegel der Ausgangsspannung an einem Mittelpunkt des Spannungsteilers bereitzustellen, wobei die Stromregelschaltung einen ersten Transistor und einen zweiten Transistor aufweist, wobei der erste Transistor ausgebildet ist, um den Strom durch den ersten Widerstand zu beeinflussen, und wobei der zweite Transistor ausgebildet ist, um den Strom durch den zweiten Widerstand zu beeinflussen, wobei Steuerspannungen des ersten Transistors und des zweiten Transistors von dem ermittelten Gleichtaktpegel der Ausgangsspannung abgängig sind, wobei der erste Transistor und der zweite Transistor Feldeffekttransistoren sind, wobei die Gates der Feldeffekttransistoren mit dem Mittelpunkt des Spannungsteilers verbunden sind.

Weitere Ausführungsbeispiele schaffen ein Verfahren zum Betrieb einer Pegelwandlerschaltung. Die Pegelwandlerschaltung weist einen Eingang mit einem ersten Anschluss und einem zweiten Anschluss, einen Ausgang mit einem dritten Anschluss und einem vierten Anschluss, einen ersten Widerstand, der zwischen dem ersten Anschluss und dem dritten Anschluss geschaltet ist, einen zweiten Widerstand, der zwischen dem zweiten Anschluss und dem vierten Anschluss geschaltet ist, und eine Stromregelschaltung auf, wobei die Stromregelschaltung einen ersten Transistor und einen zweiten Transistor aufweist, wobei der erste Transistor und der zweite Transistor Feldeffekttransistoren sind, wobei die Stromregelschaltung einen Gleichtaktdetektor aufweist, der ausgebildet ist, um einen Gleichtaktpegel der Ausgangsspannung zu ermitteln, wobei der Gleichtaktdetektor einen Spannungsteiler aufweist, wobei die Gates der Feldeffekttransistoren mit dem Mittelpunkt des Spannungsteilers verbunden sind. Das Verfahren umfasst einen Schritt des Beeinflussens eines Stroms durch den ersten Widerstand und eines Stroms durch den zweiten Widerstand mit der Stromregelschaltung derart, dass eine Ausgangsspannung der Pegelwandlerschaltung einen maximal zulässigen Wert nicht überschreitet, wobei bei dem Beeinflussen des Stroms durch den ersten Widerstand und des Stroms durch den zweiten Widerstand, der Strom durch den ersten Widerstand und der Strom durch den zweiten Widerstand mit der Stromregelschaltung basierend auf der Ausgangsspannung geregelt wird, wobei der Strom durch den ersten Widerstand mit dem ersten Transistor beeinflusst wird, und wobei der Strom durch den zweiten Widerstand mit dem zweiten Transistor beeinflusst wird, wobei Steuerspannungen des ersten Transistors und des zweiten Transistors von dem ermittelten Gleichtaktpegel der Ausgangsspannung abgängig sind, wobei der Gleichtaktpegel der Ausgangsspannung an einem Mittelpunkt des Spannungsteilers bereitgestellt wird.

Ausführungsbeispiele der vorliegenden Erfindung werden bezugnehmend auf die beiliegenden Figuren näher erläutert. Es zeigen:
- Fig. 1a: ein schematisches Blockschaltbild einer Pegelwandlerschaltung;
- Fig. 1b: ein schematisches Blockschaltbild einer Pegelwandlerschaltung;
- Fig. 2a: ein schematisches Blockschaltbild einer Pegelwandlerschaltung;
- Fig. 2b: ein schematisches Blockschaltbild einer Pegelwandlerschaltung;
- Fig. 2c: ein schematisches Blockschaltbild einer Pegelwandlerschaltung, gemäß einem Ausführungsbeispiel der vorliegenden Erfindung;
- Fig. 3: ein schematisches Blockschaltbild einer Eingangsschaltung;
- Fig. 4: ein Flussdiagramm eines Verfahrens zum Betrieb einer Pegelwandlerschaltung; und
- Fig. 5: ein schematisches Blockschaltbild einer Messschaltung.

In der nachfolgenden Beschreibung der Ausführungsbeispiele der Erfindung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

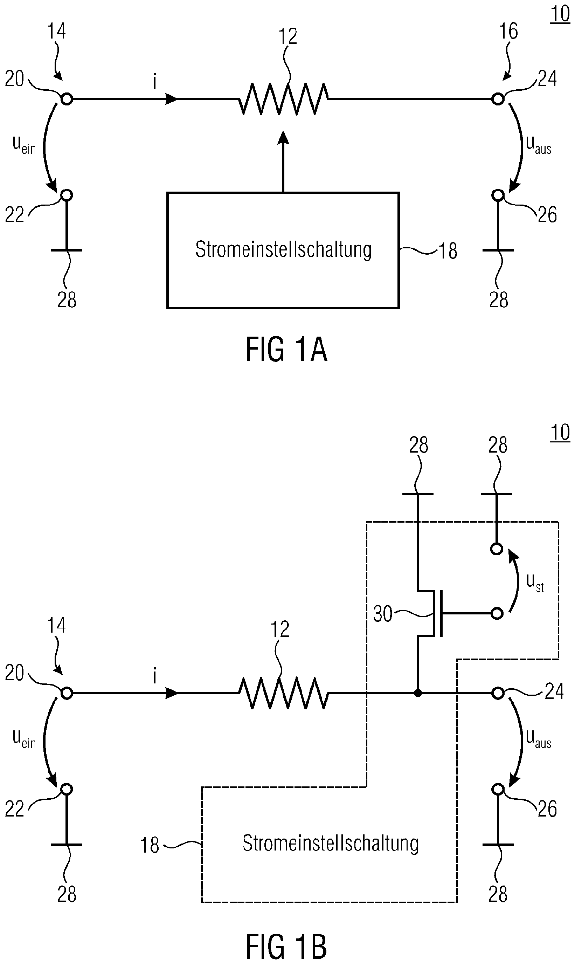

Fig. 1a zeigt ein schematisches Blockschaltbild einer Pegelwandlerschaltung 10. Die Pegelwandlerschaltung 10 weist einen Widerstand 12 auf, der zwischen einem Eingang 14 und einem Ausgang 16 der Pegelwandlerschaltung 10 geschaltet ist. Ferner weist die Pegelwandlerschaltung 10 eine Stromeinstellschaltung 18 auf, die ausgebildet ist, um einen Strom i durch den Widerstand 12 derart zu beeinflussen, dass eine Ausgangsspannung uₐᵤₛ der Pegelwandlerschaltung 10 einen maximal zulässigen Wert nicht überschreitet.

Bei Ausführungsbeispielen kann der Eingang 14 der Pegelwandlerschaltung 10 einen ersten Anschluss 20 und einen zweiten Anschluss 22 aufweisen, während der Ausgang 16 der Pegelwandlerschaltung 10 einen dritten Anschluss 24 und einen vierten Anschluss 26 aufweisen kann. Der Widerstand 12 kann dabei zwischen den ersten Anschluss 20 und den dritten Anschluss 24 geschaltet sein. Der zweite Anschluss 22 und der vierte Anschluss 26 können jeweils mit einem Referenzpotentialanschluss 28, wie z.B. Masseanschluss, verbunden sein. Zwischen dem ersten Anschluss 20 und dem zweiten Anschluss 22 kann eine Eingangsspannung uₑᵢₙ anliegen, während zwischen dem dritten Anschluss 24 und dem vierten Anschluss 26 die Ausgangsspannung uₐᵤₛ anliegen kann.

Bei Ausführungsbeispielen kann die Stromeinstellschaltung 18 kann eine Stromregelschaltung 18 sein, die ausgebildet ist, um den Strom i durch den Widerstand 12 in Abhängigkeit von der Ausgangsspannung uₐᵤₛ zu regeln.

Fig. 1b zeigt ein schematisches Blockschaltbild einer Pegelwandlerschaltung 10. Wie in Fig. 1b zu erkennen ist, kann die Stromeinstellschaltung 18 einen Transistor 30 aufweisen, der ausgebildet ist, um den Strom i durch den Widerstand 12 zu beeinflussen.

Der Transistor 30 kann zwischen einem ausgangsseitigen Anschluss des Widerstands 12 oder dem Ausgang 16 (z.B. den dritten Anschluss 24) und einem Referenzpotentialanschluss 28 geschaltet sein.

Die Stromeinstellschaltung 18 kann beispielsweise ausgebildet sein, um eine Steuerspannung uₛₜ für den Transistor 30 so bereitzustellen, dass die Steuerspannung uₛₜ des Transistors 30 von der Ausgangsspannung uₐᵤₛ abhängig ist.

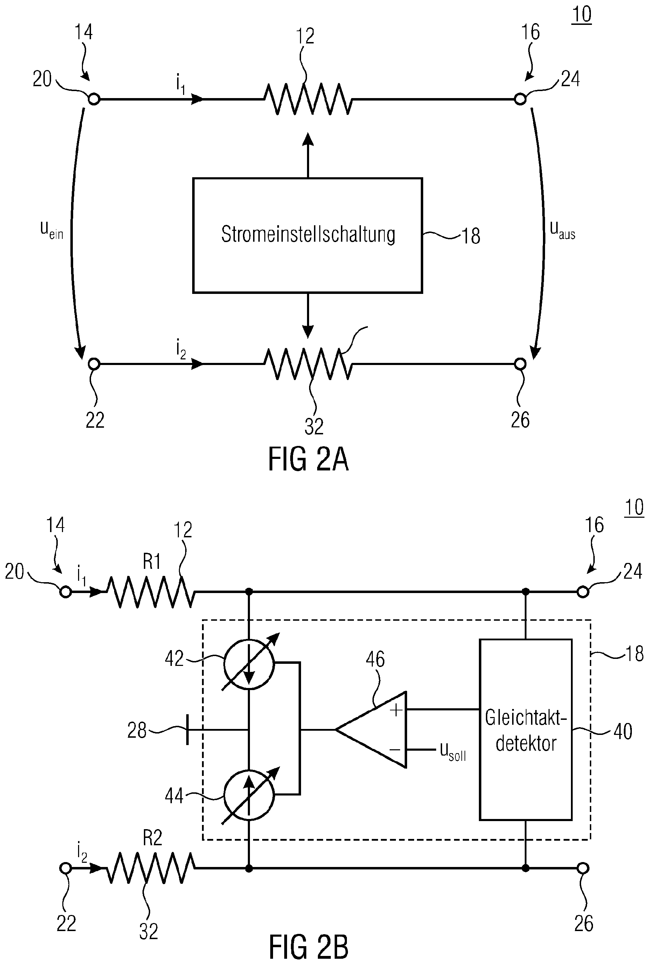

Fig. 2a zeigt ein schematisches Blockschaltbild einer Pegelwandlerschaltung 10. Die Pegelwandlerschaltung 10 weist den Eingang 14 mit dem ersten Anschluss (z.B. positiver Eingangsanschluss) 20 und dem zweiten Anschluss (z.B. negativer Eingangsanschluss) 22, den Ausgang 16 mit dem dritten Anschluss (z.B. positiver Ausgangsanschluss) 24 und dem vierten Anschluss (z.B. negativer Ausgangsanschluss) 26 auf. Ferner weist die Pegelwandlerschaltung 10 den ersten Widerstand 12, der zwischen dem ersten Anschluss 14 und dem dritten Anschluss 24 geschaltet ist, und einen zweiten Widerstand 32, der zwischen dem zweiten Anschluss 22 und dem vierten Anschluss 26 geschaltet ist, auf. Ferner weist die Pegelwandlerschaltung 10 die Stromeinstellschaltung 18 auf, die ausgebildet ist, um den Strom i₁ durch den ersten Widerstand 12 und einen Strom i₂ durch den zweiten Widerstand 32 derart zu beeinflussen, dass die Ausgangsspannung uₐᵤₛ der Pegelwandlerschaltung 10 einen maximal zulässigen Wert nicht überschreitet.

Die Stromeinstellschaltung 18 kann eine Stromregelschaltung 18 sein, die ausgebildet ist, um den Strom i₁ durch den ersten Widerstand 12 und den Strom i₂ durch den zweiten Widerstand 32 basierend auf der Ausgangsspannung uₐᵤₛ zu regeln.

Fig. 2b zeigt eine Pegelwandlerschaltung 10. Wie in Fig. 2b zu erkennen ist, kann die Stromeinstellschaltung 18 einen Gleichtaktdetektor 40 aufweisen, der ausgebildet ist, um einen Gleichtaktpegel der Ausgangsspannung uₐᵤₛ (die zwischen dem dritten Anschluss 24 und dem vierten Anschluss 26 anliegt) zu ermitteln, wobei die Stromregelschaltung 18 ausgebildet ist, um den Strom i₁ durch den ersten Widerstand 12 (R1) und den Strom i₂ durch den zweiten Widerstand 32 (R2) in Abhängigkeit von dem ermittelten Gleichtaktpegel der Ausgangsspannung uₐᵤₛ zu regeln.

Die Stromregelschaltung 18 kann ferner steuerbare Strom- oder Spannungsquellen 42 und 44 aufweisen, die ausgebildet sind, um den Strom i₁ durch den ersten Widerstand 12 (R1) und den Strom i₂ durch den zweiten Widerstand 32 (R2) zu beeinflussen. Dabei kann die Stromregelschaltung 18 ausgebildet sein, um einen Nennwert der steuerbaren Strom- oder Spannungsquellen 42 und 44 in Abhängigkeit von dem ermittelten Gleichtaktpegel der Ausgangsspannung uₐᵤₛ zu steuern.

Beispielsweise kann eine erste steuerbare Strom- oder Spannungsquelle 42 der steuerbaren Strom- oder Spannungsquellen 42 und 44 zwischen einem ausgangsseitigen Anschluss des ersten Widerstands 12 (R1) und einem Referenzpotentialanschluss 28 geschaltet sein, während eine zweite Strom- oder Spannungsquelle 44 der steuerbaren Strom- oder Spannungsquellen 42 und 44 zwischen einem ausgangsseitigen Anschluss des zweiten Widerstands 32 (R2) und den Referenzpotentialanschluss 28 geschaltet sein kann.

Ferner kann die Stromregelschaltung 18 einen Operationsverstärker 46 aufweisen, wobei ein erster Eingang (z.B. positiver Eingang) des Operationsverstärkers 46 mit dem Gleichtaktdetektor 40 verbunden sein kann, um den von dem Gleichtaktdetektor 40 ermittelten Gleichtaktpegel der Ausgangsspannung uₐᵤₛ zu erhalten, wobei ein zweiter Eingang (z.B. negativer Eingang) des Operationsverstärkers 46 eine Sollspannung uₛₒₗₗ erhalten kann, die z.B. extern oder von der Stromeinstellschaltung 18 bereitgestellt wird, und wobei ein Ausgang des Operationsverstärkers 46 mit Steuereingängen der steuerbaren Strom- oder Spannungsquellen 42 und 44 verbunden sein kann, um die steuerbaren Strom- oder Spannungsquellen 42 und 44 zu steuern.

Die Pegelwandlerschaltung 10 ermöglicht es, den Eingangspegel auf ein für die schnellen Transistoren akzeptables Niveau herabzusenken, ohne spannungsfeste, langsame Transistoren einsetzen zu müssen. Dazu wird nun ein Widerstand 12 und 32 verwendet, durch den ein (konstanter bzw. nahezu konstanter) Strom i₁ und i₂ fließt, um so einen definierten Spannungsabfall zu erzeugen. Es sei darauf hingewiesen, dass der Strom i₁ und i₂ real (ein wenig) schwanken kann. Im Weiteren kann sichergestellt werden, dass der Strom i₁ und i₂ einen ausreichenden Spannungsabfall generiert, so dass die Eingangstransistoren immer im sicheren Betriebsbereich liegen, auch dann, wenn die Betriebsspannung am Empfänger noch nicht anliegt, das sendende Gegenstück aber schon aktiv ist.

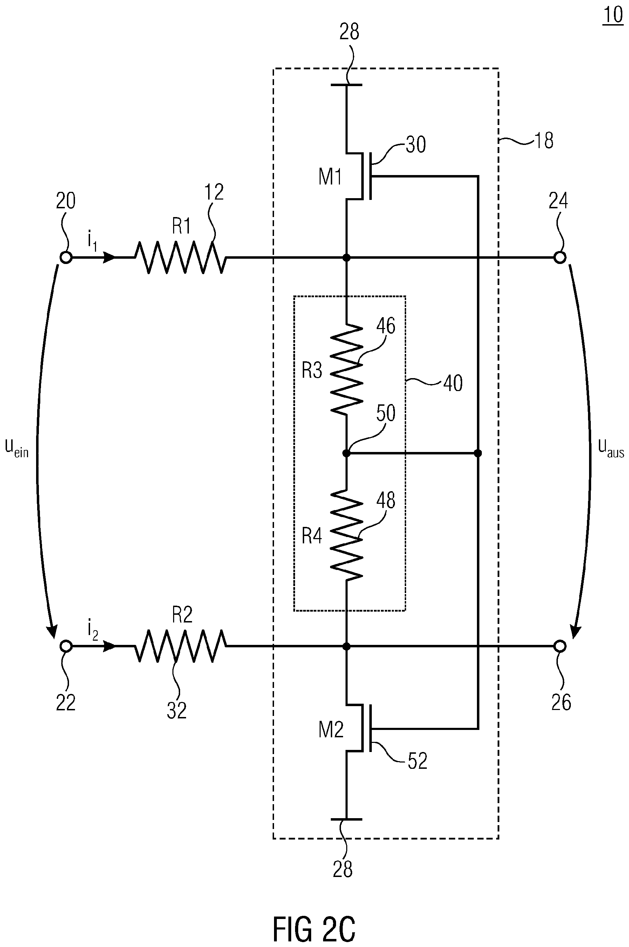

Fig. 2c zeigt ein schematisches Blockschaltbild der Pegelwandlerschaltung 10 gemäß einem Ausführungsbeispiel der vorliegenden Erfindung. Wie in Fig. 2c zu erkennen ist, kann der Gleichtaktdetektor 40 der Stromeinstellschaltung 18 einen Spannungsteiler 40 aufweisen, der ausgebildet ist, um den Gleichtaktpegel der Ausgangsspannung uₐᵤₛ bereitzustellen.

Der Spannungsteiler kann einen dritten Widerstand 46 (R3) und einen vierten Widerstand 48 (R4) aufweisen, die zwischen dem dritten Anschluss 24 und dem vierten Anschluss 26 geschaltet sind. Der Gleichtaktdetektor 40 kann ausgebildet sein, um die Gleichtaktpegel der Ausgangsspannung uₐᵤₛ an einem Knoten 50 zwischen dem dritten Widerstand 46 und dem vierten Widerstand 48 bereitzustellen.

Dabei kann ein Widerstandswert des ersten Widerstands 12 (R1) um zumindest einen Faktor 2 kleiner sein als ein Widerstandswert des dritten Widerstands 46 (R3), während ein Widerstandswert des zweiten Widerstands 32 (R2) um zumindest einen Faktor 2 kleiner sein kann als ein Widerstandswert des vierten Widerstands 48 (R4).

Die Stromregelschaltung 18 kann einen ersten Transistor 30 (M1) und einen zweiten Transistor 52 (M2) aufweisen, wobei der erste Transistor 30 ausgebildet sein kann, um den Strom i₁ durch den ersten Widerstand 12 (R1) zu beeinflussen, und wobei der zweite Transistor 52 (M2) ausgebildet sein kann, um den Strom i₂ durch den zweiten Widerstand 32 (R2) zu beeinflussen, wobei Steuerspannungen des ersten Transistors 30 (M1) und des zweiten Transistors 52 (M2) von dem ermittelten Gleichtaktpegel der Ausgangsspannung uₐᵤₛ abhängig sind.

Dabei kann der erste Transistor 30 (M1) zwischen einem ausgangsseitigen Anschluss des ersten Widerstands 12 (R1) oder dem dritten Anschluss 24 und einen Referenzpotentialanschluss 28 geschaltet sein, wobei der zweite Transistor 52 (M2) zwischen einem ausgangsseitigen Anschluss des zweiten Widerstands 32 (R2) oder dem vierten Anschluss 26 und einen Referenzpotentialanschluss 28 geschaltet sein kann.

Der erste Transistor 30 (M1) und der zweiten Transistor 52 (M2) können Feldeffekttransistoren sein.

Dabei können Gates der Feldeffekttransistoren 30 (M1) und 52 (M2) passiv gekoppelt sein, so dass Steuerspannungen an den Gates der Feldeffekttransistoren 30 (M1) und 52 (M2) ausschließlich auf einer Eingangsspannung uₑᵢₙ der Pegelwandlerschaltung 10 basieren.

Wie bereits erwähnt kann die Stromregelschaltung 18 einen Gleichtaktdetektor 40 aufweisen, der ausgebildet ist, um einen Gleichtaktpegel der Ausgangsspannung uₐᵤₛ zu ermitteln, wobei der Gleichtaktdetektor 40 einen Spannungsteiler aufweisen kann, der ausgebildet ist, um den Gleichtaktpegel der Ausgangsspannung uₐᵤₛ an einem Mittelpunkt 50 des Spannungsteilers bereitzustellen. Dabei können Gates der Feldeffekttransistoren 30 (M1) und 52 (M2) mit dem Mittelpunkt 50 des Spannungsteilers verbunden sein.

Mit anderen Worten, Fig. 2c zeigt den prinzipiellen Aufbau der Pegelwandlerschaltung 10 mit Transistoren 30 (M1) und 52 (M2). Über die Widerstände 12 und 32 (R1 und R2) fällt stromgesteuert die notwendige DC-Spannung ab. Die Widerstände 46 und 48 (R3 und R4) detektieren den Gleichtaktpegel, indem sie als Widerstandsteiler mittlere Spannung zwischen dem dritten Anschluss 24 (z.B. positiver Ausgangsanschluss) und dem vierten Anschluss 26 (z.B. negativer Ausgangsanschluss) generieren. Diese Spannung gilt als Regelgröße für die Transistoren 30 und 52 (M1 und M2), die einen DC-Strom aus den Widerständen 12 und 32 (R1 und R2) ziehen und die Pegelanpassung realisieren. Die in Pegelwandlerschaltung 10 besitzt keinen Anschluss für eine explizite Betriebsspannung und arbeitet damit auch, wenn keine Versorgungsspannung anliegt. Denkbar ist auch, dass die Kontrollspannung über komplexere Regelungen/Netzwerke feiner gesteuert wird, um einen noch größeren Eingangsbereich abdecken zu können.

Bei Ausführungsbeispielen kann eine Gateweite/Gatelänge der Transistoren 30 und 52 (M1 und M2) so gewählt werden, dass die Sollspannung Uₛₒₗₗ an den Gates Ströme (z.B. Drainstrom) erzeugt, die die notwendigen Pegelabfälle über die Widerstände 12 und 32 (R1 und R2) erzeugen. Ansonsten sind die Transistoren 30 und 52 (M1 und M2) von den folgenden Eingangstransistoren unabhängig. Dabei kann es vorteilhaft sein, die Gatelänge der Transistoren 30 und 52 (M1 und M2) möglichst groß und die Gateweite der Transistoren 30 und 52 (M1 und M2) möglichst klein zu wählen, um die kapazitive Last zu reduzieren und den internen Widerstand der Stromquelle zu erhöhen.

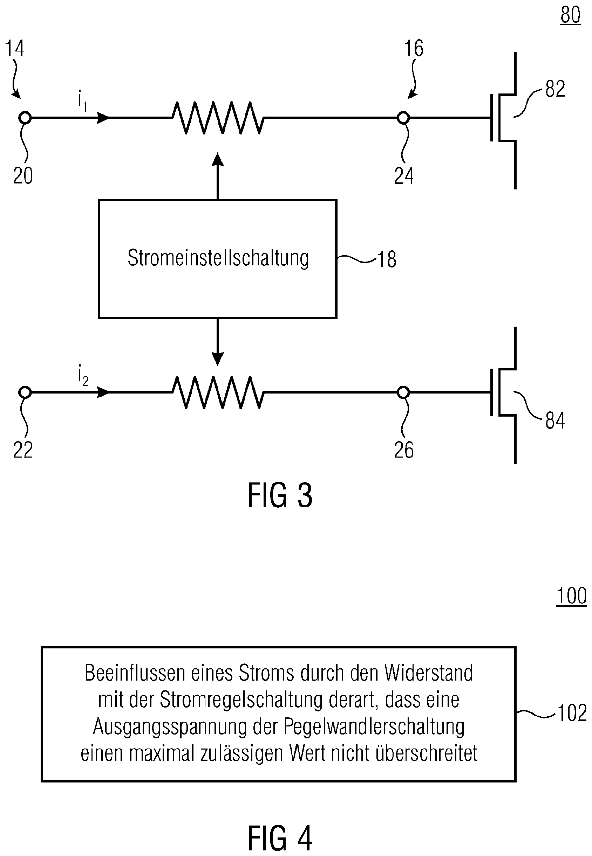

Fig. 3 zeigt ein schematisches Blockschaltbild einer Eingangsschaltung 80. Die Eingangsschaltung 80 weist Eingangstransistoren 82 und 84 und die Pegelwandlerschaltung 10 auf. Wie in Fig. 3 zu erkennen ist, können die Eingangstransistoren 82 und 84 mit dem Ausgang 16 der Pegelwandlerschaltung 10 gekoppelt sein.

Bei Ausführungsbeispielen können die Eingangstransistoren 82 und 84 direkt mit dem Ausgang 16 der Pegelwandlerschaltung 10 gekoppelt sein. Genauer genommen kann ein erster Eingangstransistor 82 der Eingangstransistoren 82 und 84 mit dem dritten Anschluss 24 verbunden sein, während ein zweiter Eingangstransistor 84 der Eingangstransistoren 82 und 84 mit dem vierten Anschluss 26 der Pegelwandlerschaltung 10 verbunden sein kann.

Fig. 4 zeigt ein Flussdiagramm eines Verfahrens 100 zum Betrieb der Pegelwandlerschaltung 10. Das Verfahren 100 umfasst Beeinflussen 102 eines Stroms durch den Widerstand mit der Stromregelschaltung derart, dass eine Ausgangsspannung der Pegelwandlerschaltung einen maximal zulässigen Wert nicht überschreitet. Das Ausführungsbeispiel der vorliegenden Erfindung schafft einen alternativen Pegelwandler 10, der den Spannungsabfall an einem Widerstand 12 und 32 realisiert, und eine Pegelwandlung ohne die Verwendung eines langsamen Transistors und damit ohne Reduktion von Bandbreite und Verstärkung erlaubt.

Die hierin beschriebene Pegelwandlerschaltung 10 hat den Vorteil eines großen Common-Mode-Bereichs, eines geringen Bandbreitenverlusts bzw. einer guten Verstärkung der Eingangsstufe, und einen Schutz der empfindlichen Eingangsstufe auch ohne aktive Betriebsspannung.

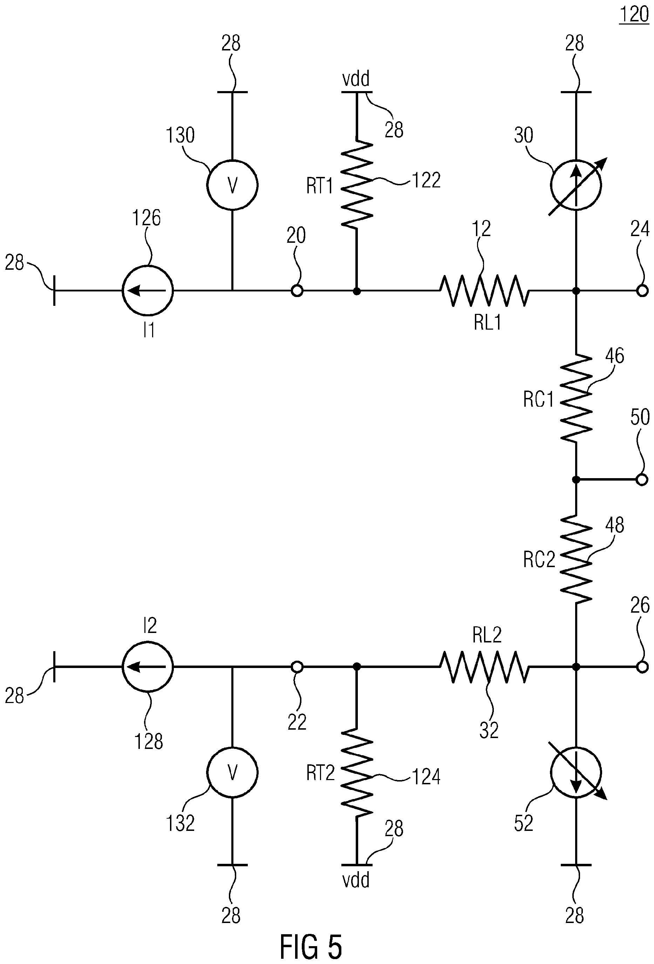

Fig. 5 zeigt ein schematisches Blockschaltbild einer Messschaltung 120. Die Messschaltung 120 umfasst die Pegelschaltung 10, die einen ersten Widerstand 12 (RL1), der zwischen einem ersten Anschluss 20 und einem dritten Anschluss 24 geschaltet ist, einen zweiten Widerstand 32 (RL2), der zwischen einem zweiten Anschluss 22 und einem vierten Anschluss 26 geschaltet ist, einen Spannungsteiler mit einem dritten Widerstand 46 (RC1) und einem vierten Widerstand 48 (RC2), die zwischen dem dritten Anschluss 24 und dem vierten Anschluss 26 geschaltet sind, eine erste gesteuerten Stromquelle 30, die zwischen dem dritten Anschluss 24 und einem Referenzpotentialanschluss 28 geschaltet ist, und eine zweite gesteuerte Stromquelle 52, die zwischen dem vierten Anschluss 26 und einem Referenzpotentialanschluss 28 geschaltet ist, aufweist.

Ferner weist die Messschaltung 120 einen fünften Widerstand 122 (RT1), der zwischen dem ersten Anschluss 20 und einem Referenzpotentialanschluss 28 geschaltet ist und einen sechsten Widerstand 124 (RT2), der zwischen dem zweiten Anschluss 22 und einem Referenzpotentialanschluss 28 geschaltet ist, auf. Des Weiteren umfasst die Messschaltung 120 eine erste Stromquelle 126, die zwischen dem ersten Anschluss 20 und einem Referenzpotentialanschluss 28 geschaltet ist, und eine zweite Stromquelle 128, die zwischen dem zweiten Anschluss 22 und einem Referenzpotentialanschluss 28 geschaltet ist. Darüber hinaus weist die Messschaltung 120 einen ersten Spannungsmesser 130, der zwischen dem ersten Anschluss 20 und einem Referenzpotentialanschluss 28 geschaltet ist, und einen zweiten Spannungsmesser 132, der zwischen dem zweiten Anschluss 22 und einem Referenzpotentialanschluss 28 geschaltet ist, auf.

Da die Schaltung Strom direkt aus den Terminierungswiderständen 122 und 124 (RT1 und RT2) zieht, lässt sich per Multimeter 130 und 132 einfach der Spannungsabfall an diesen Widerständen messen in Abhängigkeit von einem eingeprägten Strom, der eine Gleichtaktspannung am Eingang vorgibt. I1 und I2 müssen identisch sein. Bei der Pegelwandlerschaltung zeigt die Kennlinie eingespeisten I zu gemessenen U deutliche Nichtlinearitäten, wohingegen konventionelle Eingangsstufen lineare Zusammenhänge zeigen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eine Hardware-Apparats), wie zum Beispiel einen Mikroprozessor, einen programmierbaren Computer oder eine elektronische Schaltung. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Pegelwandlerschaltung (10), mit folgenden Merkmalen:
einem Eingang (14) mit einem ersten Anschluss (20) und einem zweiten Anschluss (22);
einem Ausgang (16) mit einem dritten Anschluss (24) und einem vierten Anschluss (26);
einem ersten Widerstand (12), der zwischen dem ersten Anschluss (20) und dem dritten Anschluss (24) geschaltet ist;
einem zweiten Widerstand (32), der zwischen dem zweiten Anschluss (22) und dem vierten Anschluss (26) geschaltet ist; und
einer Stromeinstellschaltung (18), die ausgebildet ist, um einen Strom (i₁) durch den ersten Widerstand (12) und einen Strom (i₂) durch den zweiten Widerstand (32) derart zu beeinflussen, dass eine Ausgangsspannung (uₐᵤₛ) der Pegelwandlerschaltung (10) einen maximal zulässigen Wert nicht überschreitet;
wobei die Stromeinstellschaltung (18) eine Stromregelschaltung (18) ist, die ausgebildet ist, um den Strom (i₁) durch den ersten Widerstand (12) und den Strom (i₂) durch den zweiten Widerstand (32) basierend auf der Ausgangsspannung (uₐᵤₛ) zu regeln;
wobei die Stromregelschaltung (18) einen Gleichtaktdetektor (40) aufweist, der ausgebildet ist, um einen Gleichtaktpegel der Ausgangsspannung (uₐᵤₛ) zu ermitteln, wobei der Gleichtaktdetektor (40) einen Spannungsteiler aufweist, der ausgebildet ist, um den Gleichtaktpegel der Ausgangsspannung (uₐᵤₛ) an einem Mittelpunkt (50) des Spannungsteilers bereitzustellen;
wobei die Stromregelschaltung (18) einen ersten Transistor (30) und einen zweiten Transistor (52) aufweist, wobei der erste Transistor (30) ausgebildet ist, um den Strom (i₁) durch den ersten Widerstand (12) zu beeinflussen, und wobei der zweite Transistor (52) ausgebildet ist, um den Strom (i₂) durch den zweiten Widerstand (32) zu beeinflussen, wobei Steuerspannungen des ersten Transistors (30) und des zweiten Transistors (52) von dem ermittelten Gleichtaktpegel der Ausgangsspannung (uₐᵤₛ) abgängig sind;
wobei der erste Transistor (30) und der zweite Transistor (52) Feldeffekttransistoren sind; und
wobei die Gates der Feldeffekttransistoren (30;52) mit dem Mittelpunkt (50) des Spannungsteilers verbunden sind.

2. Pegelwandlerschaltung (10) nach Anspruch 1, wobei die Stromregelschaltung (18) ausgebildet ist, um den Strom (i₁) durch den ersten Widerstand (12) und den Strom (i₂) durch den zweiten Widerstand (32) in Abhängigkeit von dem ermittelten Gleichtaktpegel der Ausgangspannung (uₐᵤₛ) zu regeln.

3. Pegelwandlerschaltung (10) nach einem der Ansprüche 1 bis 2, wobei der Spannungsteiler einen dritten Widerstand (46) und einen vierten Widerstand (48), die zwischen dem dritten Anschluss (24) und dem vierten Anschluss (26) geschaltet sind, aufweist, wobei der Gleichtaktdetektor (40) ausgebildet ist, um den Gleichtaktpegel der Ausgangsspannung (uₐᵤₛ) an einem Knoten (50) zwischen dem dritten Widerstand (46) und dem vierten Widerstand (48) bereitzustellen.

4. Pegelwandlerschaltung (10) nach Anspruch 3, wobei ein Widerstandswert des ersten Widerstands (12) um zumindest einen Faktor zwei kleiner ist als ein Widerstandswert des dritten Widerstands (46), und wobei ein Widerstandswert des zweiten Widerstands (32) um zumindest einen Faktor zwei kleiner ist als ein Widerstandswert des vierten Widerstands (48).

5. Pegelwandlerschaltung (10) nach einem der Ansprüche 1 bis 4, wobei die Stromregelschaltung (18) steuerbare Strom- oder Spannungsquellen (42;44) aufweist, die ausgebildet sind, um den Strom (i₁) durch ersten Widerstand (12) und den Strom (i₂) durch zweiten Widerstand (32) zu beeinflussen, wobei die Stromregelschaltung (18) ausgebildet ist, um einen Nennwert der steuerbaren Strom- oder Spannungsquellen (42;44) in Abhängigkeit von dem ermitteltem Gleichtaktpegel der Ausgangspannung (uₐᵤₛ) zu steuern.

6. Pegelwandlerschaltung (10) nach einem der Ansprüche 1 bis 5, wobei der erste Transistor (30) zwischen einem ausgangsseitigem Anschluss des ersten Widerstands (12) oder dem dritten Anschluss (24) und einem Referenzpotentialanschluss (28) geschaltet ist und wobei der zweite Transistor (52) zwischen einem ausgangsseitigem Anschluss des zweiten Widerstands (32) oder dem vierten Anschluss (26) und dem Referenzpotentialanschluss (28) geschaltet ist.

7. Pegelwandlerschaltung (10) nach einem der Ansprüche 1 bis 6, wobei Gates der Feldeffekttransistoren (30;52) passiv gekoppelt sind, so dass Steuerspannungen an den Gates der Feldeffekttransistoren (30;52) ausschließlich auf einer Eingangsspannung (uₑᵢₙ) der Pegelwandlerschaltung (10) basieren.

8. Eingangsschaltung (80), mit folgenden Merkmalen:
Eingangstransistoren (82;84); und
einer Pegelwandlerschaltung (10) nach einem der Ansprüche 1 bis 7;
wobei die Eingangstransistoren (82;84) mit dem Ausgang (16) der Pegelwandlerschaltung (10) gekoppelt sind.

9. Eingangsschaltung nach Anspruch 9, wobei die Eingangstransistoren (82;84) direkt mit dem Ausgang der Pegelwandlerschaltung (10) gekoppelt sind.

10. Verfahren (100) zum Betrieb einer Pegelwandlerschaltung (10), wobei die Pegelwandlerschaltung (10) einen Eingang (14) mit einem ersten Anschluss (20) und einem zweiten Anschluss (22), einen Ausgang (16) mit einem dritten Anschluss (24) und einem vierten Anschluss (26), einen ersten Widerstand (12), der zwischen dem ersten Anschluss (20) und dem dritten Anschluss (24) geschaltet ist, einen zweiten Widerstand (32), der zwischen dem zweiten Anschluss (22) und dem vierten Anschluss (26) geschaltet ist, und eine Stromregelschaltung (18) aufweist, wobei die Stromregelschaltung (18) einen ersten Transistor (30) und einen zweiten Transistor (52) aufweist, wobei der erste Transistor (30) und der zweite Transistor (52) Feldeffekttransistoren sind, wobei die Stromregelschaltung (18) einen Gleichtaktdetektor (40) aufweist, der ausgebildet ist, um einen Gleichtaktpegel der Ausgangsspannung (uₐᵤₛ) zu ermitteln, wobei der Gleichtaktdetektor (40) einen Spannungsteiler aufweist, wobei die Gates der Feldeffekttransistoren (30;52) mit dem Mittelpunkt (50) des Spannungsteilers verbunden sind, wobei das Verfahren (100) aufweist:
Beeinflussen (102) eines Stroms (i₁) durch den ersten Widerstand (12) und eines Stroms (i₂) durch den zweiten Widerstand (32) mit der Stromregelschaltung (18) derart, dass eine Ausgangsspannung (uₐᵤₛ) der Pegelwandlerschaltung (10) einen maximal zulässigen Wert nicht überschreitet;
wobei bei dem Beeinflussen (102) des Stroms (i₁) durch den ersten Widerstand (12) und des Stroms (i₂) durch den zweiten Widerstand (32), der Strom (i₁) durch den ersten Widerstand (12) und der Strom (i₂) durch den zweiten Widerstand (32) mit der Stromregelschaltung (18) basierend auf der Ausgangsspannung (uₐᵤₛ) geregelt wird;
wobei der Strom (i₁) durch den ersten Widerstand (12) mit dem ersten Transistor (30) beeinflusst wird, und wobei der Strom (i₂) durch den zweiten Widerstand (32) mit dem zweiten Transistor (52) beeinflusst wird;
wobei Steuerspannungen des ersten Transistors (30) und des zweiten Transistors (52) von dem ermittelten Gleichtaktpegel der Ausgangsspannung (uₐᵤₛ) abgängig sind;
wobei der Gleichtaktpegel der Ausgangsspannung an einem Mittelpunkt des Spannungsteilers bereitgestellt wird.

## Claims

1. Level converter circuit (10), comprising:
an input (14) with a first terminal (20) and a second terminal (22);
an output (16) with a third terminal (24) and a fourth terminal (26);
a first resistor (12) connected between the first terminal (20) and the third terminal (24);
a second resistor (32) connected between the second terminal (22) and the fourth terminal (26); and
a current adjustment circuit (18) configured to influence a current (i₁) through the first resistor (12) and a current (i₂) through the second resistor (32) such that an output voltage (uₒᵤₜ) of the level converter circuit (10) does not exceed a maximum allowable value;
wherein the current adjustment circuit (18) is a current regulating circuit (18) that is configured to regulate the current (i₁) through the first resistor (12) and the current (i₂) through the second resistor (32) based on the output voltage (uₒᵤₜ),
wherein the current regulating circuit (18) comprises a common mode detector (40) that is configured to determine a common mode level of the output voltage (uₒᵤₜ), wherein the common mode detector (40) comprises a voltage divider that is configured to provide the common mode level of the output voltage (uₒᵤₜ) at a center (50) of the voltage divider;
wherein the current level circuit (18) comprises a first transistor (30) and a second transistor (52), wherein the first transistor (30) is configured to influence the current (i₁) through the first resistor (12), and wherein the second transistor (52) is configured to influence the current (i₂) through the second resistor (32), wherein control voltages of the first transistor (30) and the second transistor (52) depend on the determined common mode level of the output voltage (uₒᵤₜ);
wherein the first transistor (30) and the second transistor (32) are field-effect transistors;
wherein the gates of the field-effect transistors (30; 52) are connected to the center (50) of the voltage divider.

2. Level converter circuit (10) according to claim 1, wherein the current regulating circuit (18) is configured to regulate the current (i₁) through the first resistor (12) and the current (i₂) through the second resistor (32) in dependence on the determined common mode level of the output voltage (uₒᵤₜ).

3. Level converter circuit (10) according to one of claims 1 to 2, wherein the voltage divider comprises a third resistor (46) and a fourth resistor (48) that are connected between the third terminal (24) and the fourth terminal (26), wherein the common mode detector (40) is configured to provide the common mode level of the output voltage (uₒᵤₜ) at a node (50) between the third resistor (46) and the fourth resistor (48).

4. Level converter circuit (10) according to claim 4, wherein a resistance of the first resistor (12) is lower than a resistance of the third resistor (46) by at least a factor of two and wherein a resistance of the second resistor (32) is lower than a resistance of the fourth resistor (48) by at least a factor of two.

5. Level converter circuit (10) according to one of claims 1 to 4, wherein the current regulating circuit (18) comprises controllable current or voltage sources (42; 44) that are configured to influence the current (i₁) through the first resistor (12) and the current (i₂) through the second resistor (32), wherein the current regulating circuit (18) is configured to control a nominal value of the controllable current or voltage sources (42; 44) in dependence on the determined common mode level of the output voltage (uₒᵤₜ).

6. Level converter circuit (10) according to one of claims 1 to 5, wherein the first transistor (30) is connected between an output side terminal of the first resistor (12) or the third terminal (24) and a reference potential terminal (28), and wherein the second transistor (52) is connected between an output side terminal of the second resistor (32) or the fourth terminal (26) and the reference potential terminal (28).

7. Level converter circuit (10) according to one of claims 1 to 6, wherein gates of the field-effect transistors (30; 52) are passively coupled, such that control voltages at the gates of the field-effect transistors (30; 52) are based exclusively on an input voltage (uᵢₙ) of the level converter circuit (10).

8. Input circuit (80) comprising:
input transistors (82; 84); and
a level converter circuit (10) according to one of claims 1 to 7;
wherein the input transistors (82; 84) are coupled to the output (16) of the level converter circuit (10).

9. Input circuit according to claim 9, wherein the input transistors (82; 84) are directly coupled to the output of the level converter circuit (10).

10. Method (100) for operating a level converter circuit (10), wherein the level converter circuit (10) comprises an input (14) with a first terminal (20) and a second terminal (22), an output (16) with a third terminal (24) and a fourth terminal (26), a first resistor (12) connected between the first terminal (20) and the third terminal (24), a second resistor (32) connected between the second terminal (22) and the fourth terminal (26), and a current regulating circuit (18), wherein the current level circuit (18) comprises a first transistor (30) and a second transistor (52), wherein the first transistor (30) and the second transistor (32) are field-effect transistors, wherein the current regulating circuit (18) comprises a common mode detector (40) that is configured to determine a common mode level of the output voltage (uₒᵤₜ), wherein the common mode detector (40) comprises a voltage divider, wherein the gates of the field-effect transistors (30; 52) are connected to the center (50) of the voltage divider, wherein the method (100) comprises:
influencing (102) a current (i₁) through the first resistor (12) and a current (i₂) through the second resistor (32) with the current regulating circuit (18) such that an output voltage (uₒᵤₜ) of the level converter circuit (10) does not exceed a maximum allowable value;
wherein, when influencing (102) the current (i₁) through the first resistor (12) and the current (i₂) through the second resistor (32), the current (i₁) through the first resistor (12) and the current (i₂) through the second resistor (32) are regulated by the current regulating circuit (18) based on the output voltage (uₒᵤₜ),
wherein the current (i₁) through the first resistor (12) is influenced with the first transistor (30), and wherein the current (i₁) through the second resistor (32) is influenced with the second transistor (52);
wherein control voltages of the first transistor (30) and the second transistor (52) depend on the determined common mode level of the output voltage (uₒᵤₜ);
wherein the common mode level of the output voltage is provided at a center (50) of the voltage divider.

## Revendications

1. Circuit convertisseur de niveau (10), aux caractéristiques suivantes:
une entrée (14) avec une première connexion (20) et une deuxième connexion (22);
une sortie (16) avec une troisième connexion (24) et une quatrième connexion (26);
une première résistance (12) qui est connectée entre la première connexion (20) et la troisième connexion (24);
une deuxième résistance (32) qui est connectée entre la deuxième connexion (22) et la quatrième connexion (26); et
un circuit de réglage de courant (18) configuré pour influencer un courant (i₁) passant à travers la première résistance (12) et un courant (i₂) passant à travers la deuxième résistance (32) de sorte qu'une tension de sortie (uₐᵤₛ) du circuit convertisseur de niveau (10) n'excède pas une valeur maximale admissible;
dans lequel le circuit de réglage de courant (18) est un circuit de régulation de courant (18) qui est conçu pour régler le courant (i₁) passant à travers la première résistance (12) et le courant (i₂) passant à travers la deuxième résistance (32) sur base de la tension de sortie (uₐᵤₛ);
dans lequel le circuit de réglage de courant (18) présente un détecteur de mode commun (40) qui est conçu pour déterminer un niveau de mode commun de la tension de sortie (uₐᵤₛ), dans lequel le détecteur de mode commun (40) présente un diviseur de tension qui est conçu pour mettre à disposition le niveau de mode commun de la tension de sortie (uₐᵤₛ) à un point central (50) du diviseur de tension;
dans lequel le circuit de réglage de courant (18) présente un premier transistor (30) et un deuxième transistor (52), dans lequel le premier transistor (30) est conçu pour influencer le courant (i₁) passant à travers la première résistance (12), et dans lequel le deuxième transistor (52) est conçu pour influencer le courant (i₂) passant à travers la deuxième résistance (32), dans lequel les tensions de commande du premier transistor (30) et du deuxième transistor (52) dépendent du niveau de mode commun déterminé de la tension de sortie (uₐᵤₛ);
dans lequel le premier transistor (30) et le deuxième transistor (52) sont des transistors à effet de champ; et
dans lequel les grilles des transistors à effet de champ (30; 52) sont reliées au point central (50) du diviseur de tension.

2. Circuit convertisseur de niveau (10) selon la revendication 1, dans lequel le circuit de réglage de courant (18) est conçu pour régler le courant (ii) passant à travers la première résistance (12) et le courant (i₂) passant à travers la deuxième résistance (32) en fonction du niveau de mode commun déterminé de la tension de sortie (uₐᵤₛ).

3. Circuit convertisseur de niveau (10) selon l'une des revendications 1 à 2, dans lequel le diviseur de tension présente une troisième résistance (46) et une quatrième résistance (48) qui est connectée entre la troisième connexion (24) et la quatrième connexion (26), dans lequel le détecteur de mode commun (40) est conçu pour mettre à disposition le niveau de mode commun de la tension de sortie (uₐᵤₛ) à un noeud (50) entre la troisième résistance (46) et la quatrième résistance (48).

4. Circuit convertisseur de niveau (10) selon la revendication 3, dans lequel une valeur de résistance de la première résistance (12) est inférieure d'au moins un facteur de deux à une valeur de résistance de la troisième résistance (46), et dans lequel une valeur de résistance de la deuxième résistance (32) est inférieure d'au moins un facteur de deux à une valeur de résistance de la quatrième résistance (48).

5. Circuit convertisseur de niveau (10) selon l'une des revendications 1 à 4, dans lequel le circuit de réglage de courant (18) présente des sources de courant ou de tension pouvant être commandées (42; 44) qui sont conçues pour influencer le courant (i₁) passant à travers la première résistance (12) et le courant (i₂) passant à travers la deuxième résistance (32), dans lequel le circuit de régulation de courant (18) est conçu pour régler une valeur nominale des sources de courant ou de tension pouvant être commandées (42; 44) en fonction du niveau de mode commun déterminé de la tension de sortie (uₐᵤₛ).

6. Circuit convertisseur de niveau (10) selon l'une des revendications 1 à 5, dans lequel le premier transistor (30) est connecté entre une connexion du côté de la sortie de la première résistance (12) ou de la troisième connexion (24) et une connexion de potentiel de référence (28), et dans lequel le deuxième transistor (52) est connecté entre une connexion du côté de la sortie de la deuxième résistance (32) ou de la quatrième connexion (26) et la connexion de potentiel de référence (28).

7. Circuit convertisseur de niveau (10) selon l'une des revendications 1 à 6, dans lequel les grilles des transistors à effet de champ (30; 52) sont couplées passivement, de sorte que les tensions de commande aux grilles des transistors à effet de champ (30; 52) se basent exclusivement sur une tension d'entrée (uₑᵢₙ) du circuit convertisseur de niveau (10).

8. Circuit d'entrée (80), aux caractéristiques suivantes:
des transistors d'entrée (82; 84); et
un circuit convertisseur de niveau (10) selon l'une des revendications 1 à 7;
dans lequel les transistors d'entrée (82; 84) sont couplés à la sortie (16) du circuit convertisseur de niveau (10).

9. Circuit d'entrée selon la revendication 9, dans lequel les transistors d'entrée (82; 84) sont couplés directement à la sortie du circuit convertisseur de niveau (10).

10. Procédé (100) pour faire fonctionner un circuit convertisseur de niveau (10), dans lequel le circuit convertisseur de niveau (10) présente une entrée (14) avec une première connexion (20) et une deuxième connexion (22), une sortie (16) avec une troisième connexion (24) et une quatrième connexion (26), une première résistance (12) qui est connectée entre la première connexion (20) et la troisième connexion (24), une deuxième résistance (32) qui est connectée entre la deuxième connexion (22) et la quatrième connexion (26) et un circuit de régulation de courant (18), dans lequel le circuit de régulation de courant (18) présente un premier transistor (30) et un deuxième transistor (52), dans lequel le premier transistor (30) et le deuxième transistor (52) sont des transistors à effet de champ, dans lequel le circuit de régulation de courant (18) présente un détecteur de mode commun (40) qui est conçu pour déterminer un niveau de mode commun de la tension de sortie (uₐᵤₛ), dans lequel le détecteur de mode commun (40) présente un diviseur de tension, dans lequel les grilles des transistors à effet de champ (30; 52) sont reliées au point central (50) du diviseur de tension, dans lequel le procédé (100) présente le fait de:
influencer (102) un courant (i₁) passant à travers la première résistance (12) et un courant (i₂) passant à travers la deuxième résistance (32) par le circuit de réglage de courant (18) de sorte qu'une tension de sortie (uₐᵤₛ) du circuit convertisseur de niveau (10) n'excède pas une valeur maximale admissible;
dans lequel, lors de l'influence (102) du courant (i₁) passant à travers la première résistance (12) et du courant (i₂) passant à travers la deuxième résistance (32), le courant (i₁) passant à travers la première résistance (12) et le courant (i₂) passant à travers la deuxième résistance (32) sont régulés par le circuit de régulation de courant (18) sur base de la tension de sortie (uₐᵤₛ);
dans lequel le courant (i₁) passant à travers la première résistance (12) est influencé par le premier transistor (30), et le courant (i₂) passant à travers la deuxième résistance (32) est influencé par le deuxième transistor (52);
dans lequel les tensions de commande du premier transistor (30) et du deuxième transistor (52) sont fonction du niveau de mode commun déterminé de la tension de sortie (uₐᵤₛ);
dans lequel le niveau de mode commun de la tension de sortie est mis à disposition à un point central du diviseur de tension.
